# EUROPEAN PATENT APPLICATION

(11) **EP 2 555 257 A1**
(43) Date of publication of application: **06.02.2013**
(21) Application number: 11765191.9
(22) Date of filing: 15.03.2011
(51) Int. Cl.: H01L 33/32, H01L 33/40, H01S 5/042, H01S 5/343

(54) **NITRIDE SEMICONDUCTOR ELEMENT AND MANUFACTURING METHOD THEREFOR**

(30) Priority: 01.04.2010 JP 2010085222
(71) Applicant: Panasonic Corporation, Kadoma-shi Osaka 571-8501 (JP)
(72) Inventor: YOKOGAWA, Toshiya, Osaka-shi, Osaka 540-6207 (JP); OYA, Mitsuaki, Osaka-shi, Osaka 540-6207 (JP); YAMADA, Atsushi, Osaka-shi, Osaka 540-6207 (JP); ISOZAKI, Akihiro, Osaka-shi, Osaka 540-6207 (JP)
(74) Representative: Grünecker, Kinkeldey, Stockmair & Schwanhäusser
(86) International application number: PCT/JP2011/001516
(87) International publication number: WO 2011/125289

(57) **Abstract**

A nitride-based semiconductor device of the present invention includes: a semiconductor multilayer structure **20** including a p-type GaN-based semiconductor region whose surface **12** is inclined by an angle of not less than 1° and not more than 5°; and an electrode **30** that is provided on the p-type semiconductor region. The p-type semiconductor region is made of an AlₓIn_{y}Ga_{z}N (where x+y+z=1, x≥0, y≥0, and z≥0) layer **26.** The electrode **30** includes a Zn layer **32,** and the Zn layer **32** is in contact with the surface of the p-type semiconductor region of the semiconductor multilayer structure **20.**

## Description

### TECHNICAL FIELD

The present invention relates to a nitride-based semiconductor device and a method for fabricating such a device. More particularly, the present invention relates to a GaN-based semiconductor light-emitting device such as a light-emitting diode or a laser diode that operates at wavelengths over the ultraviolet range and the entire visible radiation range, which covers blue, green, orange and white parts of the spectrum. Such a light-emitting device is expected to be applied to various fields of technologies including display, illumination and optical information processing in the near future. The present invention also relates to a method of making an electrode for use in such a nitride-based semiconductor device.

### BACKGROUND ART

A nitride semiconductor including nitrogen (N) as a Group V element is a prime candidate for a material to make a short-wave light-emitting device because its bandgap is sufficiently wide. Among other things, gallium nitride-based compound semiconductors (which will be referred to herein as "GaN-based semiconductors" and which are represented by the formula AlₓGa_{y}In_{z}N (where 0≤x, y, z≤1 and x+y+z=1)) have been researched and developed particularly extensively. As a result, blue light-emitting diodes (LEDs), green LEDs, and semiconductor laser diodes made of GaN-based semiconductors have already been used in actual products.

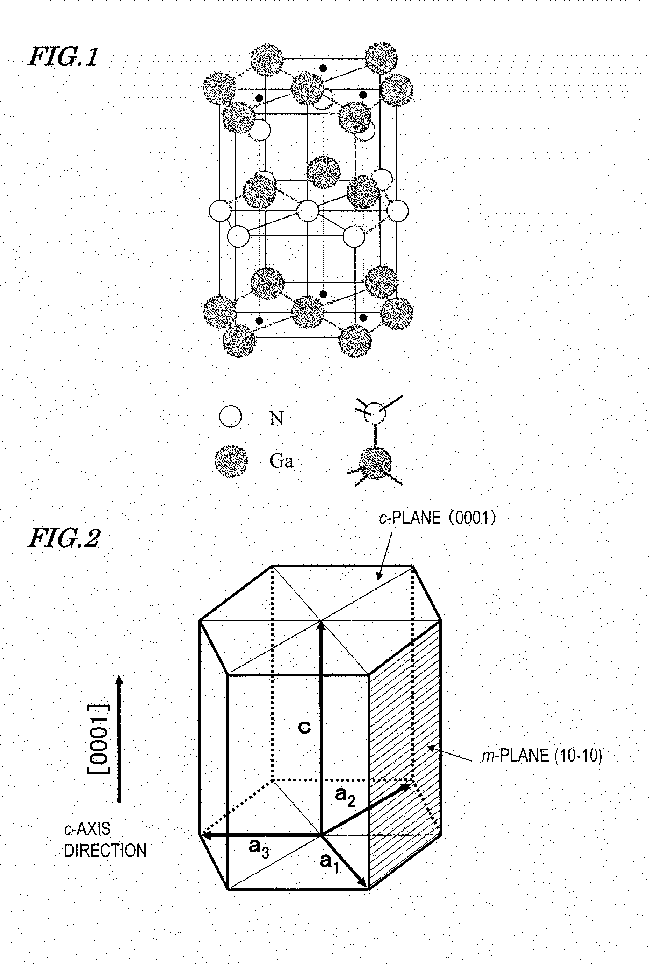

A GaN-based semiconductor has a wurtzite crystal structure. FIG. **1** schematically illustrates a unit cell of GaN. In an AlₓGa_{y}In_{z}N (where 0≤x, y, z≤1 and x+y+z=1) semiconductor crystal, some of the Ga atoms shown in FIG. **1** may be replaced with Al and/or In atoms.

FIG. **2** shows four primitive vectors **a₁, a₂, a₃** and **c,** which are generally used to represent planes of a wurtzite crystal structure with four indices (i.e., hexagonal indices). The primitive vector **c** runs in the [0001] direction, which is called a "*c*-axis". A plane that intersects with the *c*-axis at right angles is called either a "*c*-plane" or a "(0001) plane". It should be noted that the "*c*-axis" and the "*c*-plane" are sometimes referred to as "*C*-axis" and "*C*-plane".

In fabricating a semiconductor device using GaN-based semiconductors, a *c*-plane substrate, i.e., a substrate of which the principal surface is a (0001) plane, is used as a substrate on which GaN semiconductor crystals will be grown. In a *c*-plane, however, there is a slight shift in the *c*-axis direction between a Ga atom layer and a nitrogen atom layer, thus producing electrical polarization there. That is why the *c*-plane is also called a "polar plane". As a result of the electrical polarization, a piezoelectric field is generated in the InGaN quantum well of the active layer in the c-axis direction. Once such a piezoelectric field has been generated in the active layer, some positional deviation occurs in the distributions of electrons and holes in the active layer. Consequently, the internal quantum yield decreases due to the quantum confinement Stark effect of carriers, thus increasing the threshold current in a semiconductor laser diode and increasing the power dissipation and decreasing the luminous efficacy in an LED. Meanwhile, as the density of injected carriers increases, the piezoelectric field is screened, thus varying the emission wavelength, too.

Thus, to overcome these problems, it has been proposed that a substrate of which the principal surface is a non-polar plane such as a (10-10) plane that is perpendicular to the [10-10] direction and that is called an "*m*-plane" (*m-*plane GaN-based substrate) be used. As used herein, "-" attached on the left-hand side of a Miller-Bravais index in the parentheses means a "bar" (a negative direction index). As shown in FIG. **2****,** the *m*-plane is parallel to the *c*-axis (i.e., the primitive vector c) and intersects with the *c*-plane at right angles. On the *m*-plane, Ga atoms and nitrogen atoms are on the same atomic-plane. For that reason, no electrical polarization will be produced perpendicularly to the *m*-plane. That is why if a semiconductor multilayer structure is formed perpendicularly to the *m*-plane, no piezoelectric field will be generated in the active layer, thus overcoming the problems described above. The "*m*-plane" is a generic term that collectively refers to a family of planes including (10-10), (-1010), (1-100), (-1100), (01-10) and (0-110) planes.

Also, as used herein, the "X-plane growth" means epitaxial growth that is produced perpendicularly to the X plane (where X=*c* or m) of a hexagonal wurtzite structure. As for the X-plane growth, the X plane will be sometimes referred to herein as a "growing plane". A layer of semiconductor crystals that have been formed as a result of the X-plane growth will be sometimes referred to herein as an "X-plane semiconductor layer".

### CITATION LIST

### PATENT LITERATURE

Patent Document 1: Japanese Laid-Open Patent Publication No. 2001-308462
Patent Document 2: Japanese Laid-Open Patent Publication No. 2003-332697

### SUMMARY OF INVENTION

### TECHNICAL PROBLEM

As described above, a GaN-based semiconductor device that has been grown on an *m*-plane substrate would achieve far more beneficial effects than what has been grown on a *c*-plane substrate but still has the following drawback. Specifically, a GaN-based semiconductor device that has been grown on an *m*-plane substrate has higher contact resistance than what has been grown on a *c*-plane substrate, which constitutes a serious technical obstacle to using such a GaN-based semiconductor device that has been grown on an *m*-plane substrate.

Under the circumstances such as these, the present inventors wholeheartedly carried out extensive research to overcome such a problem with the prior art that a GaN-based semiconductor device, grown on an *m*-plane as a non-polar plane, would have high contact resistance. As a result, we found an effective means for reducing the contact resistance.

It is therefore an object of the present invention to provide a structure and manufacturing process that will be able to reduce the contact resistance of a GaN-based semiconductor device that has been fabricated by producing a crystal growth on an *m*-plane substrate.

### SOLUTION TO PROBLEM

A nitride-based semiconductor device of the present invention includes: a nitride-based semiconductor multilayer structure including a p-type GaN-based semiconductor region; and an electrode that is provided on a principal surface of the p-type GaN-based semiconductor region, wherein in the p-type GaN-based semiconductor region, an angle formed by a normal to the principal surface and a normal to an *m*-plane is not less than 1° and not more than 5°, and the electrode includes a Zn layer which is in contact with the principal surface of the p-type GaN-based semiconductor region.

In one embodiment, the p-type GaN-based semiconductor region is made of an AlₓIn_{y}Ga_{z}N semiconductor (where x+y+z=1, x≥0, y≥0, and z≥0).

In one embodiment, the electrode includes the Zn layer and a metal layer formed on the Zn layer, and the metal layer is formed from at least one type of metal selected from the group consisting of Pt, Mo, and Pd.

In one embodiment, the nitride-based semiconductor multilayer structure includes an active layer which includes an AlₐIn_{b}Ga_{c}N layer (where a+b+c=1, a≥0, b≥0 and c≥0), the active layer being configured to emit light.

In one embodiment, the p-type GaN-based semiconductor region is a p-type contact layer.

In one embodiment, a thickness of the Zn layer is equal to or smaller than that of the metal layer.

In one embodiment, the nitride-based semiconductor device further includes a semiconductor substrate that supports the nitride-based semiconductor multilayer structure.

In one embodiment, the Zn layer is at least partially alloyed.

In one embodiment, the Zn layer is in the form of islands.

In one embodiment, the Zn layer is formed from Zn and at least one type of metal selected from the group consisting of Pt, Mo, and Pd.

In one embodiment, the electrode is made only of the Zn layer, and the Zn layer is formed from Zn and at least one type of metal selected from the group consisting of Pt, Mo, and Pd.

A light source of the present invention includes: a nitride-based semiconductor light-emitting device; and a wavelength converter including a phosphor that converts a wavelength of light emitted from the nitride-based semiconductor light-emitting device, wherein the nitride-based semiconductor light-emitting device includes a nitride-based semiconductor multilayer structure including a p-type GaN-based semiconductor region, and an electrode that is provided on a principal surface of the p-type GaN-based semiconductor region, in the p-type GaN-based semiconductor region, an angle formed by a normal to the principal surface and a normal to an *m*-plane is not less than 1° and not more than 5°, and the electrode includes a Zn layer which is in contact with the principal surface of the p-type GaN-based semiconductor region.

In one embodiment, the p-type GaN-based semiconductor region is made of an AlₓIn_{y}Ga_{z}N semiconductor (where x+y+z=1, x≥0, y≥0, and z≥0).

In one embodiment, the Zn layer is at least partially alloyed.

A nitride-based semiconductor device fabrication method of the present invention includes the steps of: (a) providing a substrate; (b) forming on the substrate a nitride-based semiconductor multilayer structure including a p-type GaN-based semiconductor region, an angle formed by a normal to a principal surface and a normal to an *m*-plane, being not less than 1° and not more than 5°; and (c) forming an electrode on the principal surface of the p-type GaN-based semiconductor region of the nitride-based semiconductor multilayer structure, wherein step (c) includes forming a Zn layer on the principal surface of the p-type GaN-based semiconductor region.

In one embodiment, the p-type GaN-based semiconductor region is made of an AlₓIn_{y}Ga_{z}N semiconductor (where x+y+z=1, x≥0, y≥0, and z≥0).

In one embodiment, step (c) includes, after the formation of the Zn layer, forming a metal layer which is formed from at least one type of metal selected from the group consisting of Pt, Mo, and Pd.

In one embodiment, step (c) further includes performing a heat treatment on the Zn layer.

In one embodiment, the heat treatment is performed at a temperature of 400°C to 650°C.

In one embodiment, the heat treatment is performed at a temperature of 450°C to 600°C.

In one embodiment, the method further includes removing the substrate after step (b).

In one embodiment, the Zn layer is at least partially alloyed.

### ADVANTAGEOUS EFFECTS OF INVENTION

In a nitride-based semiconductor device according to the present invention, an electrode provided on a surface (*m*-plane) of a p-type GaN-based semiconductor region in a Nitride-based semiconductor multilayer structure includes a Zn layer, and the Zn layer is in contact with the surface (*m-*plane) of the p-type GaN-based semiconductor region, so that the contact resistance can be reduced. According to the present invention, even in the case of using a p-type GaN-based semiconductor region with a principal surface being inclined by an angle of not less than 1° and not more than 5° from the *m*-plane, the same effects can be achieved as those of the case where the *m*-plane GaN-based semiconductor region (the p-type GaN-based semiconductor region with a principal surface being inclined by an angle of less than 1° from the *m*-plane) is used.

### BRIEF DESCRIPTION OF DRAWINGS

FIG. **1** is a perspective view schematically illustrating a unit cell of GaN.
FIG. **2** is a perspective view showing primitive vectors **a₁, a₂, a₃** and **c** representing a wurtzite crystal structure.
FIG. **3(a)** is a schematic cross-sectional view illustrating a nitride-based semiconductor light-emitting device **100** as an embodiment of the present invention, and FIGS. **3(b)** and **3(c)** illustrate the crystal structures of an *m-*plane and a *c*-plane, respectively.
FIGS. **4(a)** to **4(c)** are diagrams schematically showing the distribution of Zn and Pt in the electrodes.
FIG. 5 is a graph which shows the specific contact resistance values (Ω·cm²) of an electrode of Pd/Pt layers and an electrode of Zn/Pt layers.
FIG. 6 is a graph which shows the dependence of the contact resistance on the heat treatment temperature.
FIG. 7 shows a graph representing the current-voltage characteristic of a light-emitting diode which includes an electrode of Zn/Pt layers and a graph representing the current-voltage characteristic of a light-emitting diode which includes a conventional electrode of Pd/Pt layers.
FIG. **8** is a cross-sectional view illustrating an embodiment of a white light source.
FIG. 9 is a cross-sectional view showing a gallium nitride-based compound semiconductor light-emitting device **100a** according to another embodiment of the present invention.
FIG. **10(a)** schematically shows the crystalline structure of the GaN-based compound semiconductor (wurtzite crystal structure). FIG. **10(b)** is a perspective view illustrating the relationship among the normal to the *m*-plane, the +*c*-axis direction, and the *a*-axis direction.
FIGS. **11(a)** and 11(b) are cross-sectional views which illustrate the positional relationship between the principal surface of the GaN-based compound semiconductor layer and the *m*-plane.
FIGS. **12(a)** and **12(b)** are cross-sectional views each schematically showing the principal surface of the p-type GaN-based compound semiconductor layer and its neighboring region.
FIG. **13** is a cross-sectional TEM image of a p-type semiconductor region which is inclined from the *m*-plane in the -c-axis direction by 1°.
FIG. **14** is a graph which illustrates the results of measurement of the contact resistance (Ω·cm²) of an electrode of Mg/Pt layers formed on a p-type semiconductor region which is inclined from the *m*-plane in the -*c*-axis direction by 0°, 2°, or 5°.

### DESCRIPTION OF EMBODIMENTS

Hereinafter, embodiments of the present invention will be described with reference to the accompanying drawings. In the drawings, any elements shown in multiple drawings and having substantially the same function will be identified by the same reference numeral for the sake of simplicity. It should be noted, however, that the present invention is in no way limited to the specific embodiments to be described below.

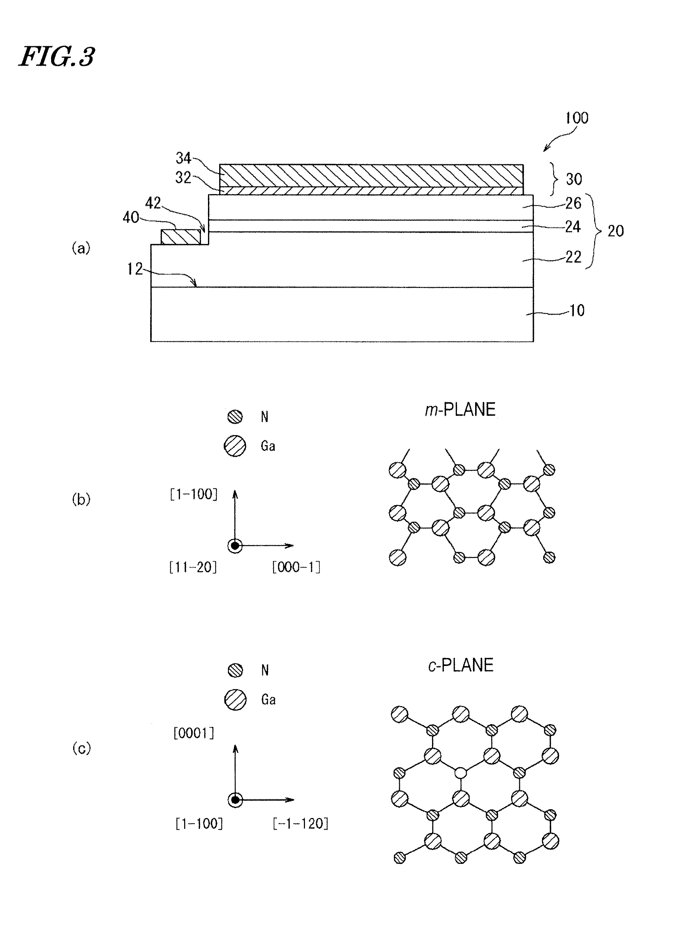

FIG. **3(a)** schematically illustrates the cross-sectional structure of a nitride-based semiconductor light-emitting device **100** as an embodiment of the present invention. What is illustrated in FIG. **3(a)** is a semiconductor device made of GaN semiconductors and has a nitride-based semiconductor multilayer structure.

The nitride-based semiconductor light-emitting device **100** of this embodiment includes a GaN-based substrate (GaN substrate) **10,** of which the principal surface **12** is an *m-*plane, a semiconductor multilayer structure **20** that has been formed on the GaN-based substrate **10,** and an electrode **30** arranged on the semiconductor multilayer structure **20.** In this embodiment, the semiconductor multilayer structure **20** is an *m*-plane semiconductor multilayer structure that has been formed through an *m*-plane crystal growth and its principal surface is an *m*-plane. It should be noted, however, that a-plane GaN could grow on an r-plane sapphire substrate in some instances. That is why according to the growth conditions, the principal surface of the GaN-based substrate **10** does not always have to be an *m*-plane. In the semiconductor multilayer structure **20** of the present invention, at least the surface of its semiconductor region that is in contact with an electrode needs to be an *m*-plane.

The nitride-based semiconductor light-emitting device **100** of this embodiment includes the GaN-based substrate **10** to support the semiconductor multilayer structure **20.** However, the device **100** may have any other substrate instead of the GaN-based substrate **10** and could also be used without the substrate.

FIG. **3(b)** schematically illustrates the crystal structure of a nitride-based semiconductor, of which the principal surface is an *m*-plane, as viewed on a cross section thereof that intersects with the principal surface of the substrate at right angles. Since Ga atoms and nitrogen atoms are present on the same atomic-plane that is parallel to the *m*-plane, no electrical polarization will be produced perpendicularly to the *m*-plane. That is to say, the *m*-plane is a non-polar plane and no piezoelecrtric field will be produced in an active layer that grows perpendicularly to the *m*-plane. It should be noted that In and Al atoms that have been added will be located at Ga sites and will replace the Ga atoms. Even if at least some of the Ga atoms are replaced with those In or Al atoms, no electrical polarization will still be produced perpendicularly to the *m*-plane.

Such a GaN-based substrate, of which the principal surface is an *m*-plane, will be referred to herein as an "*m-*plane GaN-based substrate". To obtain a nitride-based semiconductor multilayer structure that has grown perpendicularly to the *m*-plane, typically such an *m*-plane GaN substrate may be used and semiconductors may be grown on the *m*-plane of that substrate. However, the principal surface of the substrate does not have to be an *m*-plane as described above, and the device as a final product could already have its substrate removed.

The crystal structure of a nitride-based semiconductor, of which the principal surface is a *c*-plane, as viewed on a cross section thereof that intersects with the principal surface of the substrate at right angles is illustrated schematically in FIG. **3(c)** just for a reference. In this case, Ga atoms and nitrogen atoms are not present on the same atomic-plane, and therefore, electrical polarization will be produced perpendicularly to the *c*-plane. Such a GaN-based substrate, of which the principal surface is a *c*-plane, will be referred to herein as a "*c*-plane GaN-based substrate".

A *c*-plane GaN-based substrate is generally used to grow GaN-based semiconductor crystals thereon. In such a substrate, a Ga (or In) atom layer and a nitrogen atom layer that extend parallel to the *c*-plane are slightly misaligned from each other in the c-axis direction, and therefore, electrical polarization will be produced in the c-axis direction.

Referring to FIG. **3(a)** again, on the principal surface (that is an *m*-plane) **12** of the *m*-plane GaN-based substrate **10,** the semiconductor multilayer structure **20** is formed. The semiconductor multilayer structure **20** includes an active layer **24** including an AlₐIn_{b}Ga_{c}N layer (where a+b+c=1, a≥0, b≥0 and c≥0), and an Al_{d}GaₑN layer (where d+e=1, d≥0 and e≥0) **26,** which is located on the other side of the active layer **24** opposite to the surface **12.** In this embodiment, the active layer **24** is an electron injection region of the nitride-based semiconductor light-emitting device **100.**

The semiconductor multilayer structure **20** of this embodiment has other layers, one of which is an AlᵤGaᵥIn_{w}N layer (where u+v+w=1, u≥0, v≥0 and w≥0) **22** that is arranged between the active layer **24** and the GaN-based substrate **10.** The AlᵤGaᵥIn_{w}N layer **22** of this embodiment has first conductivity type, which may be n-type, for example. Optionally, an undoped GaN layer could be inserted between the active layer **24** and the Al_{d}GaₑN layer **26.**

In the Al_{d}GaₑN layer **26,** the mole fraction d of Al does not have to be uniform, but could vary either continuously or stepwise, in the thickness direction. In other words, the Al_{d}GaₑN layer **26** could have a multilayer structure in which a number of layers with mutually different Al mole fractions d are stacked one upon the other, or could have its dopant concentration varied in the thickness direction. To reduce the contact resistance, the uppermost portion of the Al_{d}GaₑN layer **26** (i.e., the upper surface region of the semiconductor multilayer structure **20**) is preferably a layer that has an Al mole fraction d of zero (i.e., a GaN layer).

An electrode **30** has been formed on the semiconductor multilayer structure **20.** The electrode **30** of this embodiment may be an electrode including a Zn layer **32.** Provided on the Zn layer **32** is a metal layer **34** made of Pt. In the electrode **30,** the Zn layer **32** is in contact with the p-type semiconductor region of the semiconductor multilayer structure **20** and functions as a portion of a p-electrode. The Zn layer **32** may be at least partially made of an alloy. Specifically, only part of the Zn layer **32** at the boundary with the metal layer **34** may be made of an alloy. Alternatively, the entire Zn layer **32** may be made of an alloy.

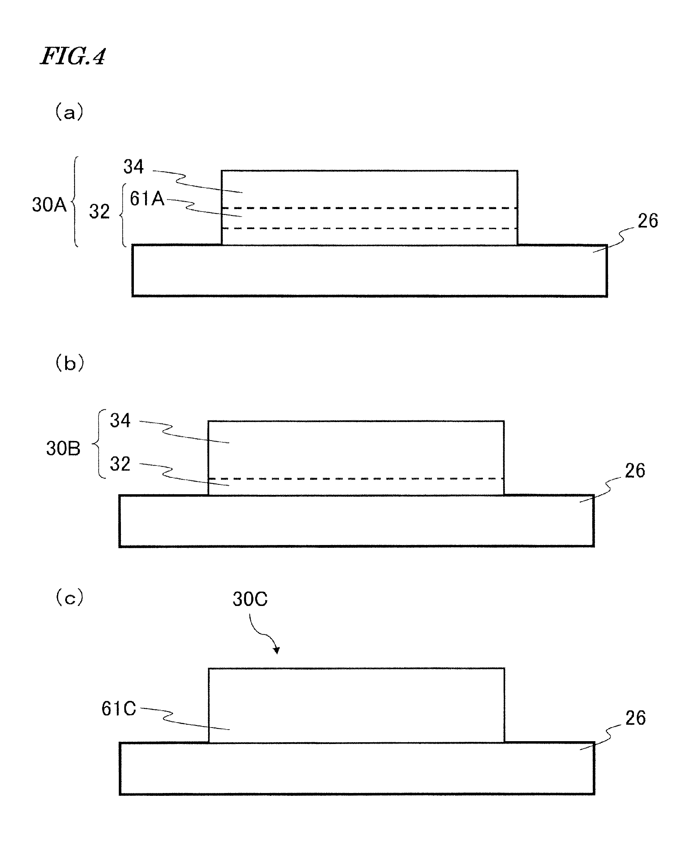

FIGS. **4(a)** to **4(c)** are diagrams for illustrating the process of alloying the Zn layer **32.** FIG. **4(a)** shows a state of the structure in which part (upper part) of the Zn layer **32** has been alloyed. The electrode **30A** includes the Zn layer **32** that is in contact with the Al_{d}GaₑN layer **26** and the metal layer **34** lying over the Zn layer **32.** The upper part of the Zn layer **32** is made of a Zn-Pt alloy layer **61A.**

FIG. **4(b)** shows a state of the structure in which alloying of Zn and Pt has advanced such that the alloyed portion is in contact with the Al_{d}GaₑN layer **26.** In the state shown in FIG. **4(b)****,** the Zn layer **32** included in the electrode **30B** (a portion of the electrode **30B** which is in contact with the Al_{d}GaₑN layer **26**) is made of a Zn-Pt alloy. In the example of the electrode **30B** shown in FIG. **4(b)****,** the metal layer **34** is lying over the Zn layer **32.**

FIG. **4(c)** shows a state of the electrode **30c** in which the Zn layer and the Pt layer have been entirely alloyed. In this state, the electrode **30C** is made only of a Zn-Pt alloy layer **61C**.

The Zn-Pt alloys shown in FIGS. **4(a)** to **4(c)** are made of Zn and Pt (i.e., the major constituents are Zn and Pt). The structures shown in FIGS. **4(a)** to **4(c)** can be formed by forming a metal layer on a Zn layer and thereafter performing a heat treatment on these layers. Note that the structure shown in FIG. **4(c)** may be formed by performing a vapor deposition using a mixture or compound of a metal that constitutes the metal layer **34** and Zn as a source material and thereafter performing a heat treatment on the deposited material.

In this embodiment, the Zn layer **32** is in contact with the Al_{d}GaₑN layer **26** that is doped with a dopant of a second conductivity type (p-type). For example, the Al_{d}GaₑN layer **26** may be doped with Mg as the dopant. Examples of other preferred p-type dopants include Zn and Be.

The metal layer **34** that is in contact with the surface of the Zn layer **32** is not limited to a Pt layer but may also be made of a metal that would make an alloy with Zn less easily than Au (e.g., Mo or Pd). In other words, at least one type of metal selected from the group consisting of Pt, Mo, and Pd may be used. As the material of the metal layer **34** that is in contact with the Zn layer **32**, Au (gold) is not preferred because it would readily be alloyed with Zn.

Note that at least part of the Zn layer **32** may undergo aggregation to form islands due to a heat treatment performed after the deposition, so that the islands are separated from one another with spaces. In this case, Pt atoms that constitute the metal layer **34** intervene between the respective Zn islands. At least part of the metal layer **34** may undergo aggregation to form islands.

In the present embodiment, the thickness of the electrode **30** is, for example, from 10 nm to 200 nm. In the electrode **30,** the thickness of the Zn layer **32** is smaller than that of the metal layer **34.** The thickness of the Zn layer **32** is, for example, from 2 nm to 50 nm. Note that "the thickness of the Zn layer **32"** herein refers to the thickness of the Zn layer after the heat treatment. When the thickness of the Zn layer **32** is 50 nm or less, peeling off of the electrode is prevented in the process of fabricating a light-emitting element.

The thickness of the metal layer (e.g., Pt layer) **34** is, for example, from 10 nm to 200 nm. The reason why the thickness of the Zn layer **32** is smaller than that of the metal layer **34** is to prevent separation of the Zn layer **32** and the Al_{d}GaₑN layer **26** which would be caused due to disturbed balance of strain between the Zn layer **32** and the metal layer **34.**

Meanwhile, the GaN-based substrate **10,** of which the principal surface **12** is an *m*-plane, may have a thickness of 100 µm to 400 µm, for example. This is because if the wafer has a thickness of at least approximately 100 µm, then there will be no trouble handling such a wafer. It should be noted that as long as the GaN-based substrate **10** of this embodiment has an *m*-plane principal surface **12** made of a GaN-based material, the substrate **10** could have a multilayer structure. That is to say, the GaN-based substrate **10** of this embodiment could also refer to a substrate, at least the principal surface **12** of which is an *m*-plane. That is why the entire substrate could be made of a GaN-based material. Or the substrate may also be made of the GaN-based material and another material in any combination.

In the structure of this embodiment, an electrode **40** has been formed as an n-side electrode on a portion of an n-type AlᵤGaᵥIn_{w}N layer **22** (with a thickness of 0.2 µm to 2 µm, for example) which is located on the GaN-based substrate **10.** In the example illustrated in FIG. **3(a)****,** in the region of the semiconductor multilayer structure **20** where the electrode **40** is arranged, a recess **42** has been cut so as to expose a portion of the n-type AlᵤGaᵥIn_{w}N layer **22.** And the electrode **40** has been formed on the exposed surface of the n-type AlᵤGaᵥIn_{w}N layer **22** at the bottom of the recess **42.** The electrode **40** may have a multilayer structure consisting of Ti, Al and Ti layers and may have a thickness of 100 nm to 200 nm, for example.

In this embodiment, the active layer **24** has a GaInN/GaN multi-quantum well (MQW) structure (with a thickness of 81 nm, for example) in which Ga_{0.9}In_{0.1}N well layers (each having a thickness of 9 nm, for example) and GaN barrier layers (each having a thickness of 9 nm, for example) are alternately stacked one upon the other.

On the active layer **24,** stacked is the p-type Al_{d}GaₑN layer **26,** which may have a thickness of 0.2 µm to 2 µm. Optionally, an undoped GaN layer could be inserted between the active layer **24** and the Al_{d}GaₑN layer **26** as described above.

In addition, a GaN layer of the second conductivity type (which may be p-type, for example) could be formed on the Al_{d}GaₑN layer **26.** Furthermore, a contact layer of p⁺-GaN and the Zn layer **32** could be stacked in this order on that GaN layer. In that case, the GaN contact layer could also be regarded as forming part of the Al_{d}GaₑN layer **26,** not a layer that has been stacked separately from the Al_{d}GaₑN layer **26.**

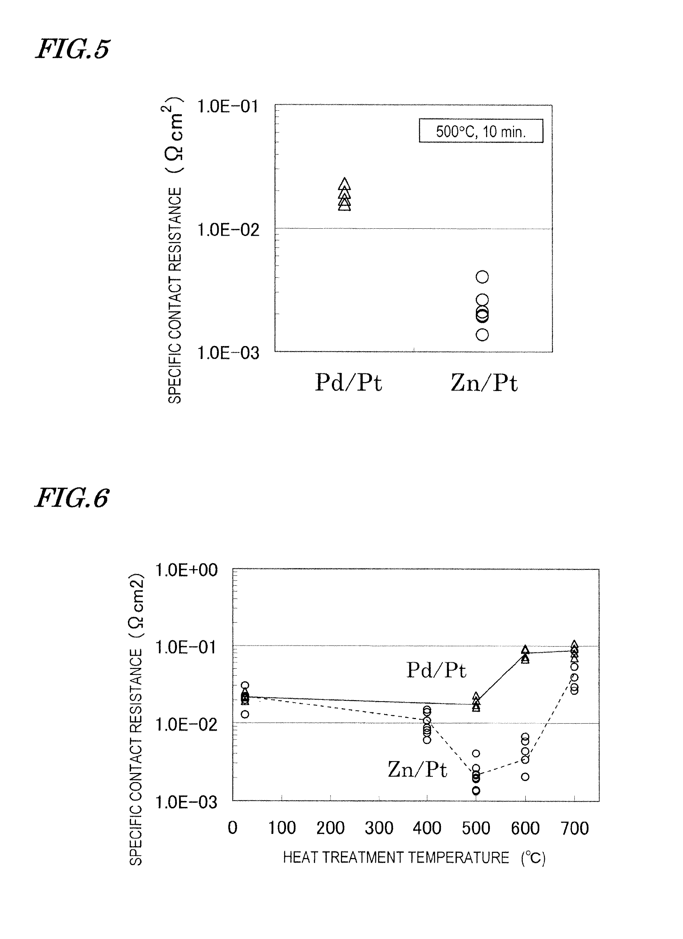

Next, the feature and specificity of the present embodiment are described in more detail with reference to FIG. **5** and FIG. **6****.**

FIG. **5** is a graph showing the specific contact resistance (Ω·cm²) of the Pd/Pt electrode and the Zn/Pt electrode. The Pd/Pt electrode used herein was an electrode formed by depositing a 40 nm thick Pd layer and a 35 nm thick Pt layer on a p-type *m*-plane GaN layer and thereafter performing a heat treatment on the resultant structure at 500°C for 10 minutes in a nitrogen atmosphere (*m*-plane GaN (Pd/Pt)). The Zn/Pt electrode used herein was an electrode formed by depositing a 7 nm Zn layer and a 75 nm Pt layer on a p-type *m*-plane GaN layer and thereafter performing a heat treatment on the resultant structure at 500°C for 10 minutes in a nitrogen atmosphere (*m*-plane GaN (Zn/Pt)). In all the experimental examples disclosed in the present application, the Zn layer and the Pt layer were deposited by a common electron beam evaporation process.

The Zn/Pt electrode and the Pd/Pt electrode are both in contact with the Mg-doped *m*-plane GaN layer. The *m*-plane GaN layer that is in contact with these electrodes is doped with 7×10¹⁹ cm⁻³ Mg to a depth of 20 nm as measured from the surface (i.e., the uppermost surface region with a thickness of 20 nm). On the other hand, the rest of the *m*-plane GaN layer, of which the depth exceeds 20 nm as measured from the surface, is doped with 1×10¹⁹ cm⁻³ Mg. If the concentration of the p-type dopant is locally increased in this manner in the uppermost surface region of the GaN layer that is in contact with the p-electrode, the contact resistance can be reduced to the lowest possible level. On top of that, by adopting such a doping scheme, the in-plane non-uniformity of the current-voltage characteristic can also be reduced. As a result, the variation in drive voltage between respective chips can also be reduced. That is why in every experimental example disclosed in this application, the surface region of the p-type GaN layer that is in contact with the electrode is doped with 7×10¹⁹ cm⁻³ Mg to a depth of 20 nm as measured from the surface, while the other deeper region is doped with 1×10¹⁹ cm⁻³ Mg.

The specific contact resistance was evaluated using the TLM (Transmission Line Method). Referring to the ordinate axis, "1.0E-01" means "1.0×10⁻¹", and "1.0E-02" means "1.0×10⁻²". Hence, "1.0E+X" means "1.0×10^{X}".

In general, contact resistance R is inversely proportional to the contact area S (cm²). Where R(Q) is the contact resistance, the relationship of R=Rc/S holds. The proportionality constant, Rc, is called specific contact resistance, which equals to the contact resistance R when the contact area S is 1 cm². Thus, the value of the specific contact resistance does not depend on the contact area S and hence serves as an index for evaluation of the contact characteristic. Hereinafter, "specific contact resistance" is sometimes abbreviated as "contact resistance".

As seen from FIG. **5****,** the Zn/Pt electrode exhibits a lower specific contact resistance (Ω·cm²) than the Pd/Pt electrode by approximately one order of magnitude.

WO 2010/113406 discloses that the contact resistance obtained when an electrode containing Zn is in contact with a c-plane p-type GaN layer is equal to or slightly higher than that obtained when the Pd/Pt electrode is in contact with a c-plane GaN layer. It is also disclosed on the other hand that, when the contact surface is an *m-*plane, the electrode containing Zn exhibits a significantly lower contact resistance than the Pd/Pt electrode. It is inferred from this result that the present invention that employs the Zn/Pt electrode would produce similar effects.

The research of the present inventor showed that the current-voltage characteristic of the conventional Pd/Pt electrode was a Schottky-type non-ohmic characteristic (Schottky voltage: about 2 V), whereas no Schottky voltage was detected in the current-voltage characteristic of the Zn/Pt electrode. It was hence found that the Zn/Pt electrode substantially forms an ohmic contact with the p-type *m*-plane GaN layer. Disappearance of the Schottky voltage is critical in decreasing the operating voltages of devices, such as light-emitting diodes, laser diodes, etc.

Generally, in fabrication of an excellent p-electrode of a low contact resistance on c-plane GaN, using a metal of a large work function, for example, Pd (work function=5.1 eV) or Pt (work function=5.6 eV), is common knowledge in the art. The work function of Zn (4.3 eV) is smaller than those of other contact electrode materials.

For comparison purposes, the present inventor formed a Zn layer as the p-electrode on a p-type *c*-plane GaN layer and evaluated the contact resistance using a TLM method. The Zn layer, which was the subject of the evaluation, was 200 nm thick as deposited and was subjected to a heat treatment at 500°C for 10 minutes in a nitrogen atmosphere. As a result, the contact resistance of the Zn layer formed on the c-plane GaN layer was a very high value, about 3.0×10⁻¹ Ω·cm².

For the reasons described above, it is estimated that preferred contact characteristics will never be achieved even when a Zn layer is used for a p-type contact electrode of *m*-plane GaN. The inventor of the present application dared to form a Zn layer so as to be in contact with the *m-*plane of the p-type GaN and performed a heat treatment. The inventor of the present application found such a phenomenon that the contact resistance can be greatly reduced by performing an appropriate heat treatment, and reached completion of the present invention. The reason for the decrease of the contact resistance has not been identified but is inferred to be due to specific behaviors of Ga atoms and N atoms in the vicinity of the surface of *m*-plane GaN as will be described later.

The inventor of the present application used a variety of metals of different work functions, such as Al, Ni, Au, Pd, Pt, etc., as the material of the electrodes for *m*-plane GaN, and measured the contact resistance of the electrodes. As a result, the inventor of the present application experimentally demonstrated that, even in the case of the *m*-plane GaN, lower contact resistances are achieved by metals of larger work functions (Pd and Pt). See WO 2010/052810.

Next, preferred heat treatment conditions are described. FIG. **6** is a graph which shows the dependence of the specific contact resistance of the Pd/Pt electrode and the Zn/Pt electrode on the heat treatment temperature. The Pd/Pt electrodes used herein were electrodes formed by depositing a 40 nm thick Pd layer and a 35 nm thick Pt layer on a p-type *m*-plane GaN layer and thereafter performing a heat treatment on the resultant structure at different temperatures in a nitrogen atmosphere (*m*-plane GaN (Pd/Pt)). The Zn/Pt electrodes used herein were electrodes formed by depositing a 7 nm Zn layer and a 75 nm Pt layer on a p-type *m*-plane GaN layer and thereafter performing a heat treatment on the resultant structure at different temperatures in a nitrogen atmosphere (*m*-plane GaN (Zn/Pt)).

As seen from FIG. **6**, in the case of the *m*-plane GaN (Pd/Pt) electrode, the contact resistance of the *m*-plane GaN scarcely changed after the heat treatment at 500°C. At heat treatment temperatures higher than 500°C, an increase of the contact resistance was detected.

On the other hand, in the case of the *m*-plane GaN (Zn/Pt) electrode, the contact resistance sharply decreased at temperatures higher than 400°C. And, at 500°C, the contact resistance further decreased. When the temperature was further increased to 600°C, the contact resistance was higher than that obtained when the heat treatment temperature was 500°C but was smaller than the contact resistance obtained in the case of the conventional *m*-plane GaN (Pd/Pt) electrode.

Therefore, the heat treatment temperature for the *m*-plane GaN (Zn/Pt) is preferably 400°C or higher, for example. The upper limit of the heat treatment temperature is preferably 700°C or less because, if it exceeds 700°C to reach a predetermined temperature (e.g., 800°C) or higher, deterioration in the film quality of the electrode and the GaN layer would increase. More preferably, it is in the temperature range of 400°C to 650°C. Still more preferably, it is in the temperature range of 450°C to 600°C.

The reason why the contact resistance greatly decreases when the electrode structure of the present embodiment (Zn/Pt) is provided on the *m*-plane GaN is inferred to be that the heat treatment allows only Ga atoms to be diffused toward the electrode side while N atoms are not diffused toward the electrode side. It is inferred that only Ga of the GaN is diffused toward the electrode side, and accordingly, the concentration of N is lower than the concentration of Ga in the Zn layer.

When Ga of the p-type GaN is diffused toward the electrode side, the outermost surface of the p-type GaN is lacking Ga atoms, i.e., Ga vacancies are formed. The Ga vacancies have acceptor-like properties, and therefore, as the number of Ga vacancies increases in the vicinity of the interface between the electrode and the p-type GaN, holes more readily pass through the Schottky barrier of this interface by means of tunneling. Thus, it is inferred that the contact resistance decreases when the Zn layer is formed so as to be in contact with the *m*-plane surface of the p-type GaN layer.

On the other hand, when N atoms as well as Ga atoms are diffused toward the electrode side, the outermost surface of the p-type GaN is lacking N atoms, i.e., N vacancies are also formed. Since the N vacancies have donor-like properties, charge compensation occurs between the Ga vacancies and the N vacancies at the outermost surface of the p-type GaN. It is also inferred that the omission of the N atoms would degrade the crystallinity of GaN crystals. Thus, when N atoms as well as Ga atoms are diffused toward the electrode side, the contact resistance between the p-type GaN layer and the electrode is high.

It is inferred that the behaviors of respective ones of such elements (Ga, N) occur even when some of Ga atoms are replaced by Al or In atoms in the GaN layer with which the Zn layer is in contact. It is also inferred that the same applies even when the GaN-based semiconductor layer with which the Zn layer is in contact is doped with an element other than Mg as a dopant.

Next, referring again to FIG. **3(a)****,** the structure of the present embodiment is described in more detail.

As shown in FIG. **3(a)****,** the light-emitting device **100** of the present embodiment includes the *m*-plane GaN-based substrate **10** and the AlᵤGaᵥIn_{w}N layer **22** (where u+v+w=1, u≥0, v≥0, w≥0) provided on the GaN-based substrate **10.** In this example, the *m*-plane GaN-based substrate **10** is an n-type GaN substrate (for example, 100 µm thick). The AlᵤGaᵥIn_{w}N layer **22** is an n-type GaN layer (for example, 2 µm thick). Provided on the AlᵤGaᵥIn_{w}N layer **22** is an active layer **24.** In other words, a semiconductor multilayer structure **20** including at least the active layer **24** is provided on the *m*-plane GaN-based substrate **10.**

In the semiconductor multilayer structure **20,** an active layer **24** including an AlₐIn_{b}Ga_{c}N layer (where a+b+c=1, a≥0, b≥0 and c≥0) has been formed on the AlₓGa_{y}In_{z}N layer **22.** The active layer **24** consists of InGaN well layers with an In mole fraction of approximately 25% and GaN barrier layers, both the well layers and the barrier layers may have a thickness of 9 nm each, and the well layers may have a well layer period of three. On the active layer **24,** stacked is an Al_{d}GaₑN layer (where d+e=1, d≥0 and e≥0) **26** of the second conductivity type (which may be p-type, for example), which may be an AlGaN layer with an A1 mole fraction of 10% and may have a thickness of 0.2 µm. In this embodiment, the Al_{d}GaₑN layer **26** is doped with Mg as a p-type dopant to a level of approximately 10¹⁸ cm⁻³, for example. Also, in this example, an undoped GaN layer (not shown) is interposed between the active layer **24** and the Al_{d}GaₑN layer **26.**

Furthermore, in this example, on the Al_{d}GaₑN layer **26,** stacked is a GaN layer (not shown) of the second conductivity type (which may be p-type, for example). In addition, on the contact layer of p⁺-GaN, stacked in this order are a Zn layer **32** and a metal layer **34.** And this stack of the Zn layer **32** and the metal layer **34** is used as an electrode (i.e., a p-electrode) **30.**

This semiconductor multilayer structure **20** further has a recess **42** that exposes the surface of the AlᵤGaᵥIn_{w}N layer **22.** And an electrode **40** (n-electrode) has been formed on the AlᵤGaᵥIn_{w}N layer **22** at the bottom of the recess **42,** which may have a width (or diameter) of 20 µm and a depth of 1 µm, for example. The electrode **40** may have a multilayer structure consisting of Ti, Al and Pt layers, which may have thicknesses of 5 nm, 100 nm and 10 nm, respectively.

The present inventors discovered that the nitride-based semiconductor light-emitting device **100** of this embodiment could have an operating voltage **Vop** that was approximately 2.0 V lower than that of a conventional *m*-plane LED with a Pd/Pt electrode, and therefore, could cut down the power dissipation as a result.

Next, a method for fabricating the nitride-based semiconductor light-emitting device **100** of this embodiment is described while still referring to FIG. **3(a)****.**

First of all, an *m*-plane GaN-based substrate **10** is prepared. In this embodiment, a GaN substrate is used as the GaN-based substrate **10.** The GaN substrate of this embodiment is obtained by HVPE (hydride vapor phase epitaxy).

For example, a thick GaN film is grown to a thickness of several millimeters on a c-plane sapphire substrate, and then diced perpendicularly to the *c*-plane (i.e., parallel to the *m*-plane), thereby obtaining *m*-plane GaN substrates. However, the GaN substrate does not have to be prepared by this particular method. Alternatively, an ingot of bulk GaN may be made by a liquid phase growth process such as a sodium flux process or a melt-growth method such as an ammonothermal process and then diced parallel to the m-plane.

The substrate does not have to be a GaN substrate but may also be a gallium oxide substrate, an SiC substrate, an Si substrate or a sapphire substrate, for example. To grow an *m*-plane GaN-based semiconductor on the substrate by epitaxy, the principal surface of the SiC or sapphire substrate is preferably also an *m*-plane. However, in some instances, a-plane GaN could grow on an r-plane sapphire substrate. That is why according to the growth conditions, the surface on which the crystal growth should take place does not always have to be an *m*-plane. In any case, at least the surface of the semiconductor multilayer structure **20** should be an *m*-plane. In this embodiment, crystal layers are formed one after another on the GaN-based substrate **10** by MOCVD (metalorganic chemical vapor deposition) process.

Next, an AlᵤGaᵥIn_{w}N layer **22** is formed on the *m*-plane GaN-based substrate **10.** As the AlᵤGaᵥIn_{w}N layer **22**, AlGaN may be deposited to a thickness of 3 µm, for example. A GaN layer may be deposited by supplying TMG(Ga(CH₃)₃), TMA(Al(CH₃)₃) and NH₃ gases onto the *m*-plane GaN-based substrate **10** at 1,100°C, for example.

Subsequently, an active layer **24** is formed on the AlᵤGaᵥIn_{w}N layer **22.** In this example, the active layer **24** has a GaInN/GaN multi-quantum well (MQW) structure in which Ga_{0.9}In_{0.1}N well layers and GaN barrier layers, each having a thickness of 9 nm, have been stacked alternately to have an overall thickness of 81 nm. When the Ga_{0.9}In_{0.1}N well layers are formed, the growth temperature is preferably lowered to 800°C to introduce In.

Thereafter, an undoped GaN layer is deposited to a thickness of 30 nm, for example, on the active layer **24,** and then an Al_{d}GaₑN layer **26** is formed on the undoped GaN layer. As the Al_{d}GaₑN layer **26,** p-Al_{0.14}Ga_{0.86}N is deposited to a thickness of 70 nm by supplying TMG, NH₃, TMA, TMI gases and Cp₂Mg (cyclopentadienyl magnesium) gas as a p-type dopant.

Next, a p-GaN contact layer is deposited to a thickness of 0.5 µm, for example, on the Al_{d}GaₑN layer **26.** In forming the p-GaN contact layer, Cp₂Mg is supplied as a p-type dopant.

Thereafter, respective portions of the p-GaN contact layer, the Al_{d}GaₑN layer **26,** the undoped GaN layer, and the active layer **24** are removed by performing a chlorine-based dry etching process, thereby making a recess **42** and exposing a region of the AlₓGa_{y}In_{z}N layer **22** where an n-electrode will be formed. Then, Ti/Pt layers are deposited as an electrode **40** on the region reserved for an n-type electrode at the bottom of the recess **42.**

On the p-GaN contact layer, a Zn layer **32** is formed using a common vapor deposition method (a resistance heating method, an electron beam evaporation process, or the like), and a metal layer **34** is further formed on the Zn layer **32** to obtain an electrode **30.** The Zn layer **32** may be formed by sputtering, a thermal CVD process, or a molecular beam epitaxy (MBE), as well as a vacuum vapor deposition method.

Optionally, the GaN-based substrate **10** and a portion of the AlᵤGaᵥIn_{w}N layer **22** could be removed after that by some technique such as laser lift-off, etching or polishing. In that case, either only the GaN-based substrate **10** or the GaN-based substrate **10** and a portion of the AlᵤGaᵥIn_{w}N layer **22** could be removed selectively. It is naturally possible to leave the GaN-based substrate **10** and the AlᵤGaᵥIn_{w}N layer **22** as they are without removing them. By performing these process steps, the nitride-based semiconductor light-emitting device **100** of this embodiment is completed.

In the nitride-based semiconductor light-emitting device **100** of this embodiment, when a voltage is applied to between the electrodes **40** and **30,** holes are injected from the electrode **30** into the active layer **24** and electrons are injected from the electrode **40** into the active layer **24,** thus producing photoluminescence with a wavelength of about 450 nm.

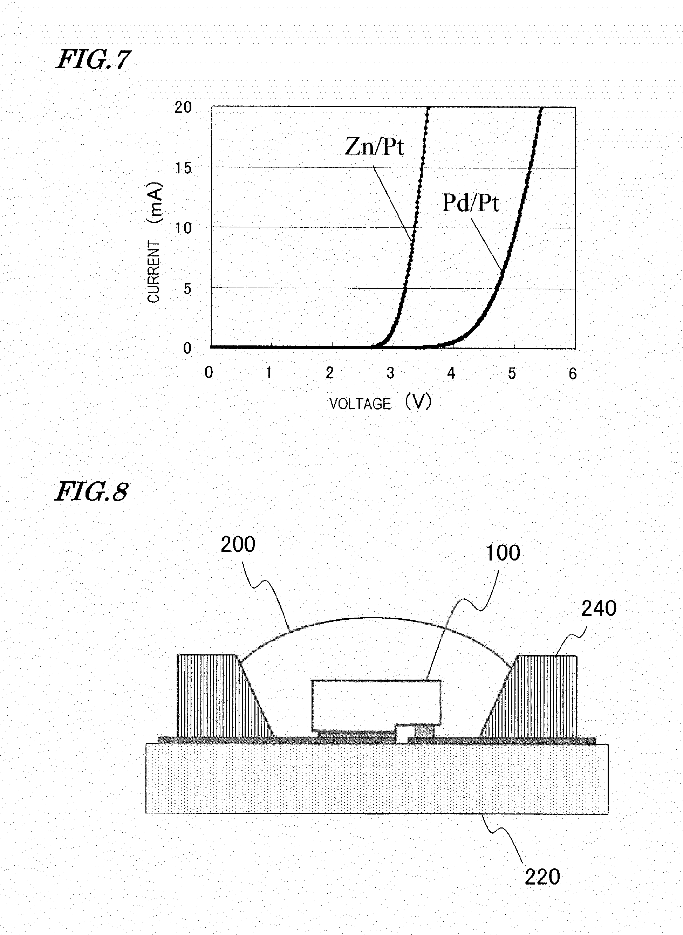

FIG. **7** shows the current-voltage characteristic of a light-emitting diode which includes an electrode formed by Zn/Pt layers. For comparison purposes, the characteristic of a light-emitting diode which has the same nitride-based semiconductor structure of the light-emitting diode but includes an electrode formed by Pd/Pt layers is also shown together. In the Zn/Pt electrode before the heat treatment, the thickness of the Zn layer was 7 nm, and the thickness of the Pt layer was 75 nm. In the Pd/Pt electrode before the heat treatment, the thickness of the Pd layer was 40 nm, and the thickness of the Pt layer was 35 nm. The Zn/Pt electrode was subjected to a heat treatment at 500°C for 10 minutes. The Pd/Pt electrode was subjected to a heat treatment at 500°C for 10 minutes.

The threshold voltage of the light-emitting diode which includes the electrode of Pd/Pt layers was about 3.7 V, whereas the threshold voltage of the light-emitting diode which includes the electrode of Zn/Pt layers was about 2.7 V. This means a considerable reduction of the threshold voltage. Comparing in terms of the operating voltage for the current value of 20 mA, it is seen that the operating voltage of the light-emitting diode which includes the electrode of Zn/Pt layers is smaller than that of the electrode of Pd/Pt layers by 2.0 V or more.

The present embodiment employs Zn as the material of the p-electrode, which is more abundant on the earth than Pd. Zn is more resistant to oxidation than Mg. The Zn layer can advantageously be formed by a commonly-employed vapor deposition method. Also, it was confirmed that the adhesion between the m-plane GaN layer and the Zn layer was excellent.

While the present invention has been described with respect to the embodiments thereof, this invention is in no way limited to those specific embodiments but could be modified in numerous ways and may assume many embodiments other than those specifically described above.

The light-emitting device described above could be used as it is as a light source. However, if combined with a resin including a phosphor that produces wavelength conversion according to the present invention, for example, the light-emitting device can be suitably used as a light source with an expanded operating wavelength range (such as a white light source).

FIG. **8** is a schematic representation illustrating an example of such a white light source. The light source shown in FIG. **8** includes a nitride-based semiconductor light-emitting device **100** with the structure shown in FIG. **3(a)** and a resin layer **200** in which particles of a phosphor such as YAG (Yttrium Aluminum Garnet) are dispersed to change the wavelength of the light emitted from the nitride-based semiconductor light-emitting device **100** into a longer one. The nitride-based semiconductor light-emitting device **100** is mounted on a supporting member **220** on which a wiring pattern has been formed. And on the supporting member **220,** a reflective member **240** is arranged so as to surround the nitride-based semiconductor light-emitting device **100.** The resin layer **200** has been formed so as to cover the nitride-based semiconductor light-emitting device **100.**

Note that the contact structure of the present invention provides the above-described excellent effects when the p-type semiconductor region that is in contact with the Zn layer is formed of a GaN-based semiconductor, specifically an AlₓIn_{y}Ga_{z}N semiconductor (x+y+z=1, x≥0, y≥0, z≥0). As a matter of course, such an effect of reducing the contact resistance can also be obtained in light-emitting devices other than LEDs (e.g., semiconductor lasers) and devices other than the light-emitting devices (e.g., transistors and photodetectors).

An actual surface (principal surface) of the *m-*plane semiconductor layer does not need to be perfectly parallel to the *m*-plane but may be inclined from the *m*-plane by a small angle (which is greater than 0° and smaller than ±1°). Forming a substrate or semiconductor layer which has a surface perfectly parallel to the *m*-plane is difficult in view of the manufacturing techniques. Thus, when an *m*-plane substrate or *m*-plane semiconductor layer is formed using the existing manufacturing techniques, a surface actually formed would inevitably be inclined from the ideal *m*-plane. The angle and azimuth of the inclination varies depending on the manufacturing process, and therefore, precisely controlling the inclination angle and inclination azimuth of the surface is difficult. Note that the surface (principal surface) of the substrate or semiconductor is sometimes intentionally inclined from the *m*-plane by an angle of 1° or greater. A gallium nitride-based compound semiconductor light-emitting device in an embodiment which will be described below has a p-type semiconductor region whose principal surface is inclined from the *m*-plane by an angle of 1° or greater.

### [Another Embodiment]

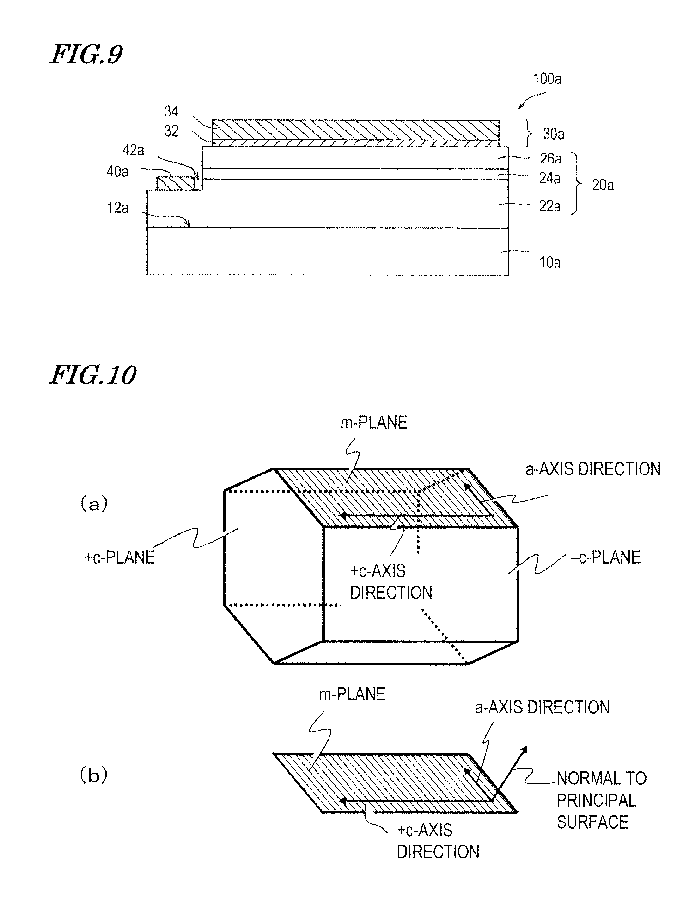

FIG. *9* is a cross-sectional view showing a nitride-based semiconductor light-emitting device **100a** of the present embodiment. To form a p-type semiconductor region whose principal surface is inclined from the *m*-plane by an angle of 1° or greater, the nitride-based semiconductor light-emitting device **100a** of the present embodiment includes a GaN substrate **10a** whose principal surface is inclined from the *m-*plane by an angle of 1° or greater. A substrate whose principal surface is inclined from the *m*-plane by an angle of 1° or greater is commonly called "off-substrate". The off-substrate can be formed by performing the step of slicing off a substrate from a monocrystalline ingot and polishing the surface of the substrate such that the surface intentionally inclined in a specific azimuth from the *m*-plane is used as the principal surface. On the GaN-based substrate **10a,** a semiconductor multilayer structure **20a** is formed. An AlᵤGaᵥIn_{w}N layer **22a,** an active layer **24a,** and an Al_{d}GaₑN layer **26a** shown in FIG. **9** have a principal surface which is inclined from the *m*-plane by an angle of 1° or greater. This is because, when respective semiconductor layers are stacked on the inclined principal surface of the substrate, the surfaces (principal surfaces) of these semiconductor layers are also inclined from the *m*-plane. The GaN-based substrate **10a** may be replaced by, for example, a sapphire substrate or SiC substrate whose surface is inclined in a specific direction from the *m*-plane. However, the configuration of the present embodiment only requires that at least the surface of the p-type semiconductor region of the semiconductor multilayer structure **20a** which is in contact with an electrode **30a** should be inclined from the *m*-plane by an angle of 1° or greater.

Next, details of the inclination of the p-type semiconductor region in the present embodiment are described with reference to FIGS. **10** to **14**.

FIG. **10(a)** schematically shows the crystalline structure of the GaN-based compound semiconductor (wurtzite crystal structure), corresponding to 90° rotation of the crystalline structure of FIG. **2**. The *c*-planes of the GaN crystal include a +*c*-plane and a -*c*-plane. The +*c*-plane is a (0001) plane over which Ga atoms are exposed and is referred to as "Ga plane". On the other hand, the -*c*-plane is a (000-1) plane over which N (nitrogen) atoms are exposed and is referred to as "N plane". The +*c*-plane and the -*c*-plane are parallel to each other. Both of these planes are perpendicular to the *m*-plane. The *c*-planes have polarity and therefore can be classified into the +*c*-plane and the -*c-*plane. Classifying the *a*-plane that is a non-polar plane into the +*a*-plane and the -*a*-plane is nonsensical.

The +*c*-axis direction shown in FIG. **10(a)** is a direction perpendicularly extending from the -*c*-plane to the +*c*-plane. On the other hand, the *a*-axis direction corresponds to the unit vector **a₂** of FIG. **2** and is oriented in [-12-10] direction that is parallel to the *m*-plane. FIG. **10(b)** is a perspective view illustrating the relationship among the normal to the *m*-plane, the +*c*-axis direction, and the *a*-axis direction. The normal to the *m*-plane is parallel to the [10-10] direction. As shown in FIG. **10(b)**, the normal to the *m*-plane is perpendicular to both the +*c*-axis direction and the *a*-axis direction.

The inclination of the principal surface of the GaN-based compound semiconductor layer from the *m*-plane by an angle of 1° or greater means that the normal to the principal surface of the semiconductor layer is inclined from the normal to the *m*-plane by an angle of 1° or greater.

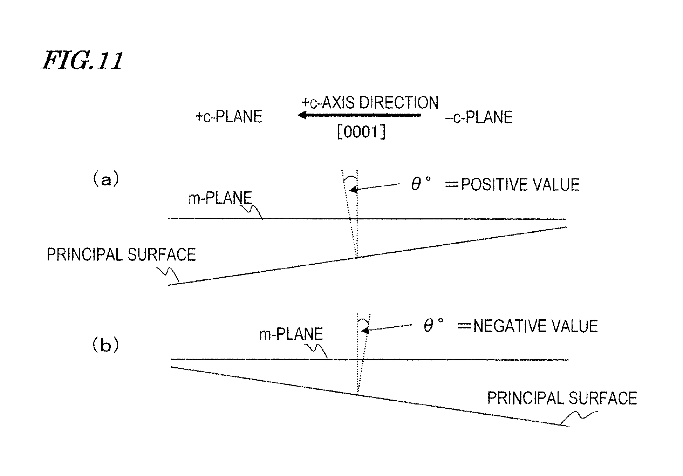

Next, refer to FIG. **11**. FIGS. **11(a)** and **11(b)** are cross-sectional views which illustrate the relationship between the principal surface of the GaN-based compound semiconductor layer and the *m*-plane. These diagrams are cross-sectional views which are perpendicular to both the *m-*plane and the c-plane. In FIG. **11****,** an arrow which represents the +*c*-axis direction is shown. As shown in FIG. **11****,** the *m-*plane is parallel to the +*c*-axis direction. Therefore, a normal vector of the *m*-plane is perpendicular to the +*c*-axis direction.

In the examples shown in FIGS. **11(a)** and 11(b), the normal vector of the principal surface of the GaN-based compound semiconductor layer is inclined in the *c*-axis direction from the normal vector of the *m*-plane. More specifically, in the example of FIG. **11(a)****,** the normal vector of the principal surface is inclined toward the +*c*-plane side. In the example of FIG. **11(b)****,** the normal vector of the principal surface is inclined toward the -*c*-plane side. In this specification, the inclination angle of the normal vector of the principal surface relative to the normal vector of the *m*-plane (inclination angle θ) in the former case is represented by a positive value, and the inclination angle θ in the latter case is represented by a negative value. In any of these cases, the statement that "the principal surface is inclined in the *c*-axis direction" holds true.

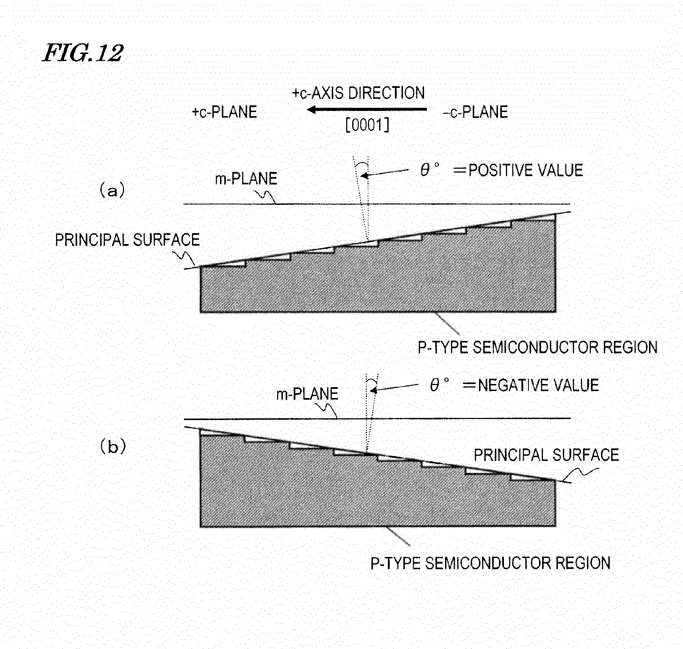

In this embodiment, the inclination angle of the p-type semiconductor region is in the range of 1° to 5° or in the range of -5° to -1°. In this case, the effects of the present invention can also be provided as well as in the case where the inclination angle of the p-type semiconductor region is greater than 0° and smaller than ±1°. Hereinafter, the reasons for this are described with reference to FIG. **12.** FIGS. **12(a)** and **12(b)** are cross-sectional views corresponding to FIGS. **11(a)** and **11(b)**, respectively, showing a neighboring region of the principal surface in the p-type semiconductor region which is inclined in the c-axis direction from the *m-*plane. When the inclination angle θ is 5° or smaller, the principal surface in the p-type semiconductor region has a plurality of steps as shown in FIGS. **12(a)** and **12(b)****.** Each step has a height equivalent to a monoatomic layer (2.7 Å). The steps are parallel to each other with generally equal intervals (30 Å or more). With such an arrangement of the steps, it can be said that the principal surface as a whole is inclined from the *m*-plane. However, upon closer observation, a large number of *m*-plane regions are exposed over the principal surface.

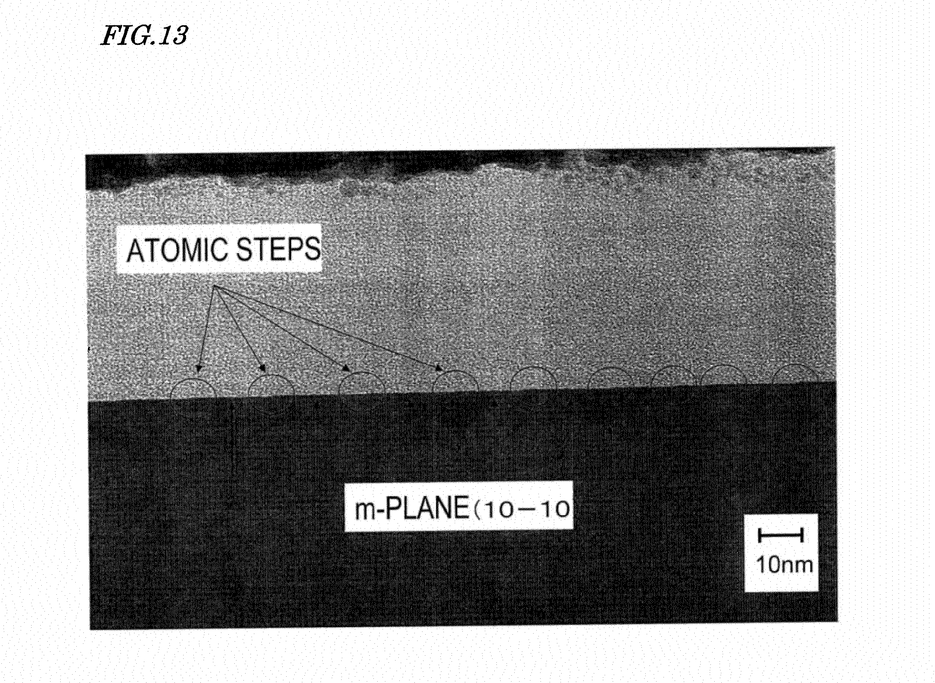

FIG. **13** is a cross-sectional TEM image of a p-type semiconductor region which is inclined from the *m*-plane in the -c-axis direction by 1°. It is seen that the *m*-plane clearly appears over the surface of the p-type semiconductor region, and the inclination is formed by atomic steps. The reason why the surface of the GaN-based compound semiconductor layer whose principal surface is inclined from the *m*-plane has such a configuration is that the *m*-plane as a crystalline plane is intrinsically very stable. It is inferred that basically the same phenomenon would occur even when the inclination direction of the normal vector of the principal surface is directed to a plane orientation different from the +*c*-plane and the -*c*-plane. When the normal vector of the principal surface is inclined in for example the *a*-axis direction, basically the same phenomenon occurs so long as the inclination angle is in the range of 1° to 5°. It is thus inferred from the above that, even when the surface (principal surface) of the p-type gallium nitride compound semiconductor layer is inclined from the *m*-plane by an angle of 1° or greater, the contact resistance would not depend on the inclination angle because the surface which is in contact with the p-electrode has a number of exposed *m-*plane regions.

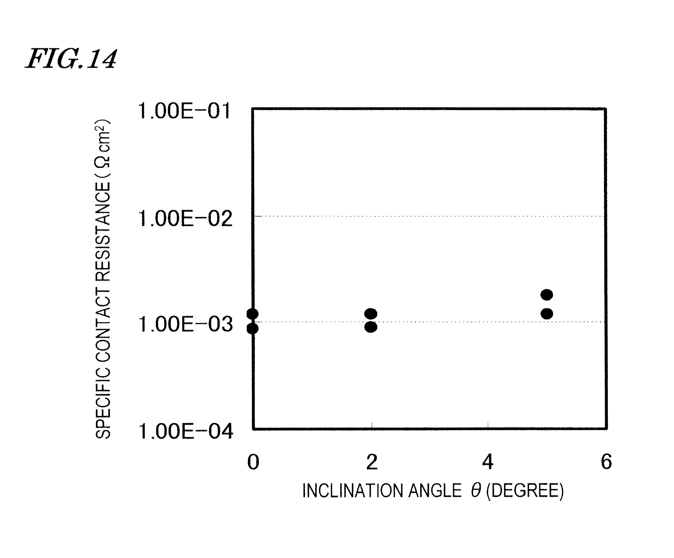

FIG. **14** is a graph which illustrates the results of measurement of the contact resistance (Ω·cm²) of an electrode of Mg/Pt layers formed on a p-type semiconductor region which is inclined from the *m*-plane in the -c-axis direction by 0°, 2°, or 5°. The ordinate axis of the graph represents the specific contact resistance, and the abscissa axis represents the inclination angle θ (the angle between the normal to the *m*-plane and the normal to the surface in the p-type semiconductor region). Note that the values of the specific contact resistance were obtained after the formation of the electrode and the heat treatment. As seen from the results of FIG. **14**, if the inclination angle θ is 5° or smaller, the contact resistance has a generally constant value. It is inferred that, in the case of using the electrode of a Zn layer, the contact resistance also has a generally constant value so long as the inclination angle θ from the *m*-plane is 5° or smaller.

From the above, it is inferred that, if the inclination angle of the surface of the p-type semiconductor region is 5° or smaller, the contact resistance decreases due to the configuration of the present invention.

Note that, when the absolute value of the inclination angle θ is greater than 5°, the internal quantum efficiency deteriorates due to a piezoelectric field. As such, if the piezoelectric field frequently occurs, realizing a semiconductor light-emitting device by means of *m*-plane growth has a small significance. Thus, according to the present invention, the absolute value of the inclination angle θ is limited to 5° or smaller. However, even when the inclination angle θ is set to for example 5°, the actual inclination angle θ may deviate from 5° by about ±1° due to variations in fabrication. Completely removing the variations in fabrication is difficult, while such a small angle deviation would not interrupt the effects of the present invention.

### INDUSTRIAL APPLICABILITY

A nitride-based semiconductor device of the present invention has a reduced contact resistance between the p-type semiconductor region in which the angle formed by the normal to the principal surface and the normal to the *m*-plane is not less than 1° and not more than 5° and the p-electrode and is therefore especially suitably used for light-emitting diodes (LED).

### REFERENCE SIGNS LIST

**10, 10a** substrate (GaN-based substrate)
**12**, **12a** surface of substrate (*m*-plane)
**20, 20a** semiconductor multilayer structure
**22, 22a** AlᵤGaᵥIn_{w}N layer
**24, 24a** active layer
**26, 26a** Al_{d}GaₑN layer
**30, 30A, 30B, 30C** p-electrode
**32** Zn layer
**34** metal layer (Pt layer)
**40, 40a** n-electrode
**42, 42a** recess
**61A, 61C** Zn-Pt alloy layer
**100, 100a** nitride-based semiconductor light-emitting device
**200** resin layer in which wavelength-converting phosphors are dispersed
**220** supporting member
**240** reflective member

## Claims

1. A nitride-based semiconductor device, comprising:
a nitride-based semiconductor multilayer structure including a p-type GaN-based semiconductor region; and
an electrode that is provided on a principal surface of the p-type GaN-based semiconductor region,
wherein in the p-type GaN-based semiconductor region, an angle formed by a normal to the principal surface and a normal to an *m*-plane is not less than 1° and not more than 5°, and
the electrode includes a Zn layer which is in contact with the principal surface of the p-type GaN-based semiconductor region.

2. The nitride-based semiconductor device of claim 1, wherein the p-type GaN-based semiconductor region is made of an AlₓIn_{y}Ga_{z}N semiconductor (where x+y+z=1, x≥0, y≥0, and z≥0).

3. The nitride-based semiconductor device of claim 1 or 2, wherein
the electrode includes the Zn layer and a metal layer formed on the Zn layer, and
the metal layer is formed from at least one type of metal selected from the group consisting of Pt, Mo, and Pd.

4. The nitride-based semiconductor device of claim 1, 2 or 3, wherein the nitride-based semiconductor multilayer structure includes an active layer which includes an AlₐIn_{b}Ga_{c}N layer (where a+b+c=1, a≥0, b≥0 and c≥0), the active layer being configured to emit light.

5. The nitride-based semiconductor device of any one of claims 1 to 4, wherein the p-type GaN-based semiconductor region is a p-type contact layer.

6. The nitride-based semiconductor device of claim 3, wherein a thickness of the Zn layer is equal to or smaller than that of the metal layer.

7. The nitride-based semiconductor device of any one of claims 1 to 6, further comprising a semiconductor substrate that supports the nitride-based semiconductor multilayer structure.

8. The nitride-based semiconductor device of any one of claims 1 to 7, wherein the Zn layer is at least partially alloyed.

9. The nitride-based semiconductor device of any one of claims 1 to 8, wherein the Zn layer is in the form of islands.

10. The nitride-based semiconductor device of any one of claims 1 to 9, wherein the Zn layer is formed from Zn and at least one type of metal selected from the group consisting of Pt, Mo, and Pd.

11. The nitride-based semiconductor device of claim 10, wherein
the electrode is made only of the Zn layer, and
the Zn layer is formed from Zn and at least one type of metal selected from the group consisting of Pt, Mo, and Pd.

12. A light source, comprising:
a nitride-based semiconductor light-emitting device; and
a wavelength converter including a phosphor that converts a wavelength of light emitted from the nitride-based semiconductor light-emitting device,
wherein the nitride-based semiconductor light-emitting device includes
a nitride-based semiconductor multilayer structure including a p-type GaN-based semiconductor region, and
an electrode that is provided on a principal surface of the p-type GaN-based semiconductor region,
in the p-type GaN-based semiconductor region, an angle formed by a normal to the principal surface and a normal to an *m*-plane is not less than 1° and not more than 5°, and
the electrode includes a Zn layer which is in contact with the principal surface of the p-type GaN-based semiconductor region.

13. The light source of claim 12, wherein the p-type GaN-based semiconductor region is made of an AlₓIn_{y}Ga_{z}N semiconductor (where x+y+z=1, x≥0, y≥0, and z≥0).

14. The light source of claim 12 or 13, wherein the Zn layer is at least partially alloyed.

15. A method for fabricating a nitride-based semiconductor device, comprising the steps of:
(a) providing a substrate;
(b) forming on the substrate a nitride-based semiconductor multilayer structure including a p-type GaN-based semiconductor region, an angle formed by a normal to a principal surface and a normal to an *m*-plane being not less than 1° and not more than 5°; and
(c) forming an electrode on the principal surface of the p-type GaN-based semiconductor region of the nitride-based semiconductor multilayer structure,
wherein step (c) includes forming a Zn layer on the principal surface of the p-type GaN-based semiconductor region.

16. The method source of claim 15, wherein the p-type GaN-based semiconductor region is made of an AlₓIn_{y}Ga_{z}N semiconductor (where x+y+z=1, x≥0, y≥0, and z≥0).

17. The method of claim 15 or 16, wherein step (c) includes, after the formation of the Zn layer, forming a metal layer which is formed from at least one type of metal selected from the group consisting of Pt, Mo, and Pd.

18. The method of claim 15, 16 or 17, wherein step (c) further includes performing a heat treatment on the Zn layer.

19. The method of claim 18, wherein the heat treatment is performed at a temperature of 400°C to 650°C.

20. The method of claim 19, wherein the heat treatment is performed at a temperature of 450°C to 600°C.

21. The method of any one of claims 15 to 20, further comprising removing the substrate after step (b).

22. The method of any one of claims 15 to 21, wherein the Zn layer is at least partially alloyed.
